# EUROPEAN PATENT SPECIFICATION

(11) **EP 2 857 347 B1**
(45) Date of publication and mention of the grant of the patent: **07.03.2018**
(21) Application number: 14183759.1
(22) Date of filing: 05.09.2014
(51) Int. Cl.: B81B 3/00, G02B 26/08, G02B 26/10

(54) **OPTICAL DEFLECTING MIRROR DEVICE HAVING FIGURE "8"-SHAPED RIB AND OPTICAL DEFLECTOR**
OPTISCHE ABLENKSPIEGELVORRICHTUNG MIT RIPPE IN FORM EINER 8 UND OPTISCHER DEFLEKTOR
DISPOSITIF DE MIROIR DE DÉVIATION OPTIQUE AYANT LA NERVURE EN FORME DE 8 ET UN DÉFLECTEUR OPTIQUE

(30) Priority: 17.09.2013 JP 2013191876
(43) Date of publication of application: 08.04.2015
(73) Proprietor: Stanley Electric Co., Ltd., Meguro-ku Tokyo 153 (JP)
(72) Inventor: Yasuda, Yoshiaki, Tokyo, 153-8636 (JP)
(74) Representative: Carstens, Dirk Wilhelm

(56) References cited:
- WO-A1-2008/089786
- US-A1- 2005 162 724
- US-A1- 2007 236 778
- US-A1- 2009 080 051
- US-A1- 2012 162 739

## Description

### BACKGROUND

### Field of the Invention

The presently disclosed subject matter relates to an optical deflector used in an optical scanner for a projector, a headlamp, a bar code reader, a laser printer, a laser head amplifier, a head-up display unit and the like, and, more particularly, to its optical deflecting mirror device.

### Description of the Related Art

Recently, optical deflectors used in optical scanners have been micro electro mechanical system (MEMS) devices manufactured by semiconductor manufacturing technology and micro machine technology.

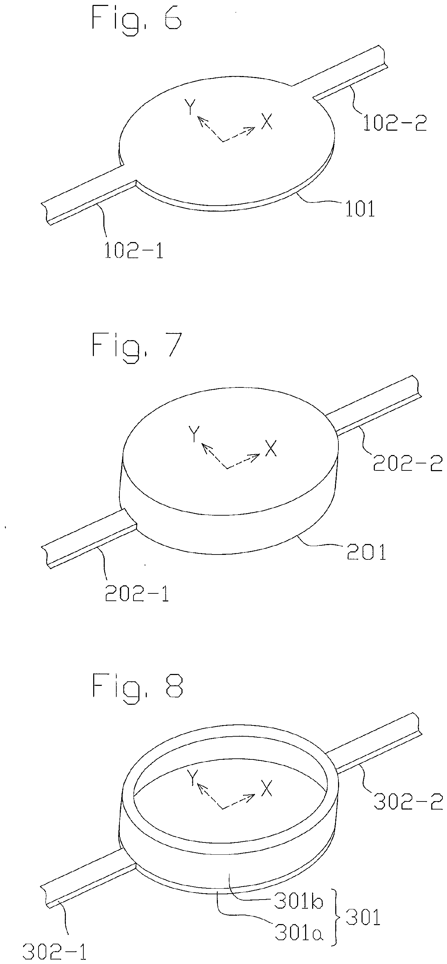

In Fig. 6, which is a rear-side perspective view illustrating a first prior art optical deflector (see: Fig. 16 of JP2001-249300), an optical deflecting mirror device 101 constructed by only a single mirror is supported by torsion bars 102-1 and 102-2 to a support frame (not shown). Also, provided between the support frame and the torsion bars 102-1 and 102-2 are actuators (not shown) serving as cantilevers. Thus, the optical deflecting mirror device 101 can be rocked around an X-axis by the actuators.

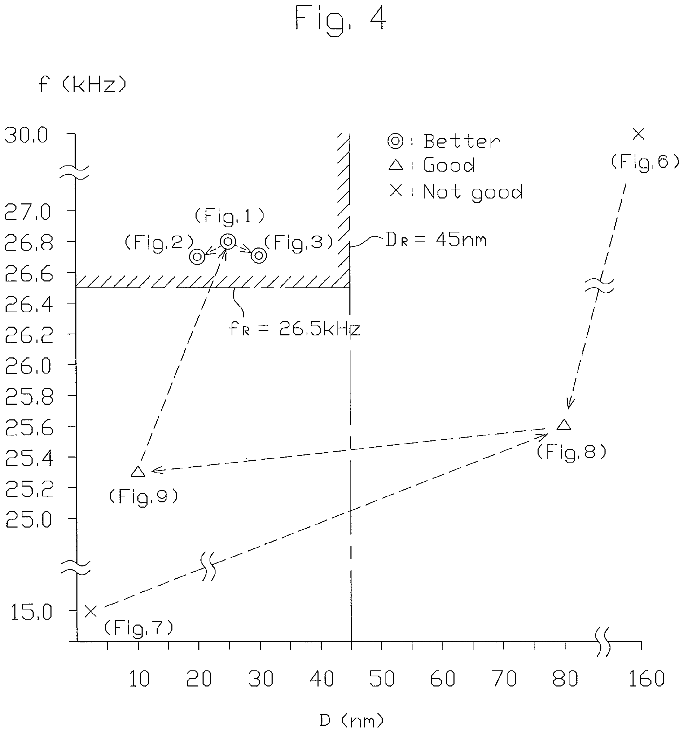

In Fig. 6, since the thickness of the optical deflecting mirror device 101 is the same as that of the torsion bars 102-1 and 102-2, the optical deflecting mirror device 101 is very thin. As a result, the moment of inertia of the optical deflecting mirror device 101 is so small that the resonant frequency "f" of the optical deflecting mirror device 101 is very large. For example, when the thickness and diameter of the optical deflecting mirror device 101 are about 40 µm and about 1.2 mm, respectively, the resonant frequency "f" of the optical deflecting mirror device 101 is 30.0 kHz or more (see: Fig. 4). Thus, the resonant frequency "f" of the optical deflecting mirror device 101 becomes higher than a required resonant frequency f_{R} (= 26. 5 kHz) in optical scanners for high definition projectors. That is, f > f_{R} is satisfied, so that the optical deflecting mirror device 101 can be driven at a higher speed than a required speed.

In the first prior art optical deflector of Fig. 6, however, since the optical deflecting mirror device 101 is very thin, the rigidity of the optical deflecting mirror device 101 is very small. Therefore, when the rocking angle of the optical deflecting mirror device 101 is large, the optical deflecting mirror device 101 is greatly deformed in a bowl shape, so that the dynamic face-deflection peak-to-valley amount D is very large. For example, when the thickness and diameter of the optical deflecting mirror device 101 are about 40µm and about 1.2 mm, respectively, the dynamic face-deflection peak-to-valley amount D of the optical deflecting mirror device 101 is about 156 nm (see: Fig. 4). Thus, the dynamic face-deflection peak-to-valley amount D of the optical deflecting mirror device 101 becomes larger than a required dynamic face-deflection peak-to-valley amount D_{R} < (= 45 nm) in optical scanners for high definition projectors. That is, D < D_{R} is not satisfied, so that the optical characteristics of reflected light of the optical deflecting mirror device 101 do not satisfy required optical characteristics in optical scanners for high definition projectors. Note that the required dynamic face-deflection peak-to-valley amount DRis defined by one-tenth of a wavelength (λ = 450nm) of a laser beam irradiated onto optical deflecting mirror devices.

In Fig. 7, which is a rear-side perspective view illustrating a second prior art optical deflector (see: JP7-092409), an optical deflecting mirror device 201 constructed by only a single mirror is thicker than torsion bars 202-1 and 202-2. Therefore, since the optical deflecting mirror device 201 is very thick, the rigidity of the optical deflecting mirror device 201 is very large. As a result, even when the rocking angle of the optical deflecting mirror device 201 is large, the optical deflecting mirror device 201 is slightly deformed in a bowl shape, so that the dynamic face-deflection peak-to-valley amount D is very small. For example, when the thickness and diameter of the optical deflecting mirror device 201 are about 200 µm and about 1.2 mm, respectively, the dynamic face-deflection peak-to-valley amount D of the optical deflecting mirror device 201 is several nm (see: Fig. 4). Thus, the dynamic face-deflection peak-to-valley amount D of the optical deflecting mirror device 201 becomes smaller than the required dynamic face-deflection peak-to-valley amount D_{R} (= 45 nm) in optical scanners for high definition projectors. That is, D < D_{R} is satisfied, so that the optical characteristics of reflected light of the optical deflecting mirror device 201 satisfy the required optical characteristics in optical scanners for high definition projectors.

In the second prior art optical deflector of Fig. 7, however, the moment of inertia of the optical deflecting mirror device 201 is so large that the resonant frequency "f" of the optical deflecting mirror device 201 is very small. For example, when the thickness and diameter of the optical deflecting mirror device 201 are about 200µm and about 1.2 mm, respectively, the resonant frequency "f" of the optical deflecting mirror device 201 is 15 kHz or less (see: Fig. 4). Thus, the resonant frequency "f" of the optical deflecting mirror device 201 becomes lower than the required resonant frequency f_{R} (= 26.5 kHz) in optical scanners for high definition projectors. That is, f > f_{R} is not satisfied, so that it is impossible to drive the optical deflecting mirror device 201 at a higher speed than the required speed.

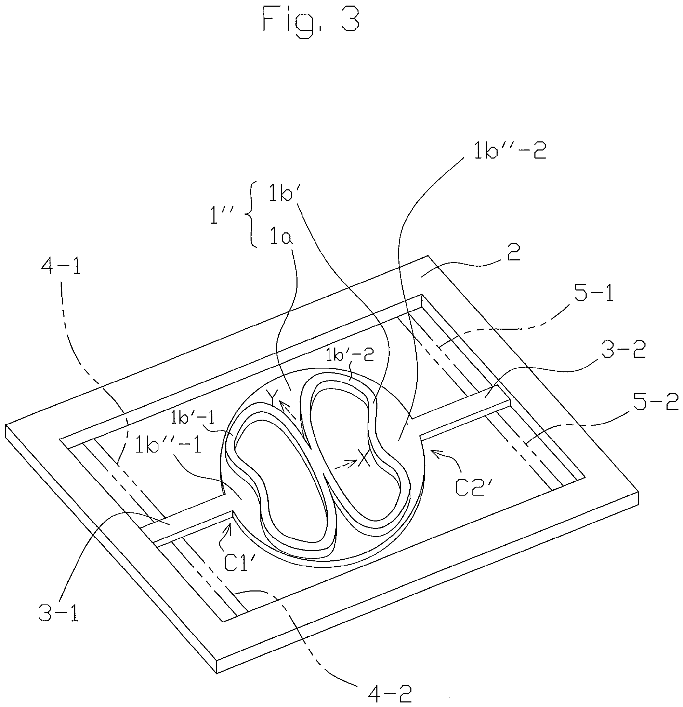

In Fig. 8, which is a rear-side perspective view illustrating a third prior art optical deflector (see: Fig. 3 of JP2010-128116), an optical deflecting mirror device 301 coupled to torsion bars 302-1 and 302-2 has a mirror 301a with a reflective front surface and a ring-shaped reinforcement rib 301b provided on a back surface of the mirror 301a. Therefore, the average thickness of the optical deflecting mirror device 301 is larger than that of the torsion bars 302-1 and 302-2.

In the third prior art optical deflector of Fig. 8, due to the presence of the ring-shaped reinforcement rib 301b, the rigidity of the optical deflecting mirror device 301 is larger than that of the optical deflecting mirror device 101 of Fig. 6, but is smaller than that of the optical deflecting mirror device 201 of Fig. 7. On the other hand, due to the presence of the ring-shaped reinforcement rib 301b, the resonant frequency "f" of the optical deflecting mirror device 301 is smaller than that of the optical deflecting mirror device 101 of Fig. 6, but is larger than that of the optical deflecting mirror device 201 of Fig. 7. For example, when the thickness and diameter of the mirror 301a are about 40 µm and about 1.2 mm, respectively, and the width and height of the ring-shaped reinforcement rib 301b are about 100 µm and about 150 µm, respectively, the dynamic face-deflection peak-to-valley amount D of the optical deflecting mirror device 301 is about 80 nm and the resonant frequency "f" of the optical deflecting mirror device 301 is about 25.6 kHz (see: Fig. 4).

In the third prior art optical deflector of Fig. 8, however, since no rib is present at the center of the mirror 301a, the rigidity of the optical deflecting mirror device 301 is still small. Therefore, when the rocking angle of the optical deflecting mirror device 301 is large, the optical deflecting mirror device 301 is greatly deformed in a bowl shape, so that the dynamic face-deflection peak-to-valley amount D is still large, i.e., about 80 nm. Thus, the dynamic face-deflection peak-to-valley amount D of the optical deflecting mirror device 301 becomes larger than the required dynamic face-deflection peak-to-valley amount D_{R} (= 45 nm) in optical scanners for high definition projectors. That is, D < D_{R} is not satisfied, so that the optical characteristics of reflected light of the optical deflecting mirror device 301 do not satisfy the required optical characteristics in optical scanners for high definition projectors.

On the other hand, in the third prior art optical deflector of Fig. 8, as the ring-shaped reinforcement rib 301b is provided at the outer circumference of the mirror 301a, the moment of inertia of the optical deflecting mirror device 301 is still large, so that the resonant frequency "f" of the optical deflecting mirror device 301 is still small. For example, the resonant frequency "f" of the optical deflecting mirror device 301 is about 25.6 kHz, as stated above. Thus, the resonant frequency "f" of the optical deflecting mirror device 301 becomes lower than the required resonant frequency f_{R} (= 26.5 kHz) in optical scanners for high definition projectors. That is, f > f_{R} is not satisfied, so that it is impossible to drive the optical deflecting mirror device 301 at a higher speed than the required speed.

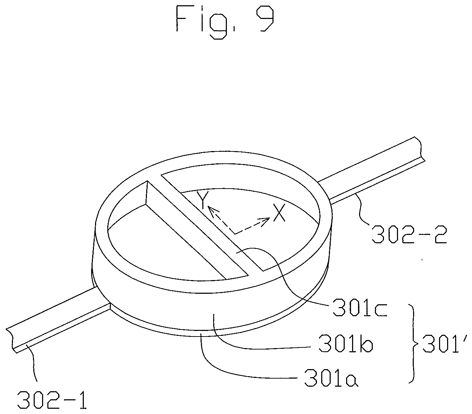

In Fig. 9, which is a rear-side perspective view illustrating a comparative example of the optical deflector of Fig. 8, the optical deflecting mirror device 301 of Fig. 8 is replaced by an optical deflecting mirror device 301' where a central reinforcement rib 301c along a Y-axis is added to the elements of the optical deflecting mirror device 301 of Fig. 8. Therefore, the rigidity of the optical deflecting mirror device 301' is larger than the optical deflecting mirror device 301 of Fig. 8, to reduce the bowl-like face-deformation of the optical deflecting mirror device 301'. Thus, the dynamic face-deflection peak-to-valley amount D is about 12 nm, which becomes smaller than the required dynamic face-deflection peak-to-valley amount DR; however, the resonant frequency "f" is about 25.3 kHz, which becomes lower than the required resonant frequency f_{R} (see: Fig. 4).

According to the above-described prior art optical deflectors as illustrated in Figs. 6, 7 and 8 and the comparative example as illustrated in Fig. 9, the suppression of the dynamic face-deflection peak-to-valley amount D of an optical deflecting mirror device has a trade-off relationship with the increase of the resonant frequency "f" of the optical deflecting mirror device.

US 2012/162739 A1 was used as a basis for the preamble of claim 1 and discloses an optical scanning device which includes a mirror, a mirror supporting part to support the mirror on an upper surface, and a pair of torsion beams to support the mirror supporting part from both sides in an axis direction and to drive the mirror supporting part so as to swing the mirror supporting part around the axis by being twisted. The torsion beams include slits approximately parallel to the axis direction.

US 2007/236778 A1 discloses an analog MEMS device with a pivotal micromirror that is supported by one or more beams that provide non-linear resistance. An electrode can electrostatically attract the micromirror, while the beam(s) provide resistance to deflection. When the forces equalize, the micromirror is held at a target angle. The beam support provides non-linear support for the micromirror.

US 2005/162724 A1 discloses a torsional hinged mirror design with reduced flexing. In addition to a central spine to prevent or reduce flexing of the tips, the mirror layer also includes perimeter ridges to reduce or prevent flexing or warping of the mirror edges. To provide an even stiffer mirror with minimum weight, either or both of the hinge plate and balancing plate may also include perimeter ridges that align with the perimeter ridges of the mirror layer.

WO 2008/089786 A1 discloses a micromechanical component which comprises a layer that is structured in order to form a spring and a plate suspended in an oscillating manner via the spring, wherein at least one recess is configured in the plate, and a cover layer is disposed on the surface of the plate, the layer closing the recess on the surface.

US 2009/080052 A1 discloses a microactuator including a base frame and a moving plate, the moving plate having both ends supported by a plurality of elastic support portions inside the base frame, the moving plate having a first side on which a reflective mirror for changing a light path is disposed. At least one first rib is disposed along an edge of a second side of the moving plate, which is the reverse side of the first side of the moving plate, and a second rib is disposed in the center of the second side of the moving plate and correspondingly encloses a permanent magnet. Also, a portion of the second side of the moving plate, except for the first and second ribs, is removed to a predetermined depth to reduce the weight of the entire moving plate and to define the first and second ribs.

### SUMMARY

The presently disclosed subject matter seeks to solve one or more of the above-described problems.

According to the presently disclosed subject matter, an optical deflecting mirror device includes a mirror with a reflective front surface, and a figure "8 "-shaped reinforcement rib provided on a rear surface of the mirror symmetrically along a rocking axis of the mirror. The figure "8 "-shaped reinforcement rib consists of two ring-shaped reinforcement ribs coupled to each other along the rocking axis.

Thus, according to the presently disclosed subject matter, the suppression of the dynamic face-deflection peak-to-valley amount D can be realized simultaneously with the increase of the resonant frequency "f".

### BRIEF DESCRIPTION OF THE DRAWINGS

The above and other advantages and features of the presently disclosed subject matter will be more apparent from the following description of certain embodiments, taken in conjunction with the accompanying drawings, as compared with the prior art and comparative example, wherein:
Fig. 1 is a rear-side perspective view illustrating a first embodiment of the one-dimensional optical deflector according to the presently disclosed subject matter;
Fig. 2 is a rear-side perspective view illustrating a second embodiment of the one-dimensional optical deflector according to the presently disclosed subject matter;
Fig. 3 is a rear-side perspective view illustrating a third embodiment of the one-dimensional optical deflector according to the presently disclosed subject matter;
Fig. 4 is a diagram showing the dynamic face-deflection peak-to-valley amounts and resonant frequencies of the first, second and third embodiments as compared with the prior art and comparative example;
Fig. 5 is a front-side perspective view illustrating a two-dimensional deflector to which the first embodiment of the one-dimensional optical deflector of Fig. 1 is applied;
Fig. 6 is a rear-side perspective view illustrating a first prior art optical deflector;
Fig. 7 is a rear-side perspective view illustrating a second prior art optical deflector;
Fig. 8 is a rear-side perspective view illustrating a third prior art optical deflector; and
Fig. 9 is a rear-side perspective view illustrating a comparative example of the third prior art optical deflector.

### DETAILED DESCRIPTION OF EXEMPLARY EMBODIMENTS

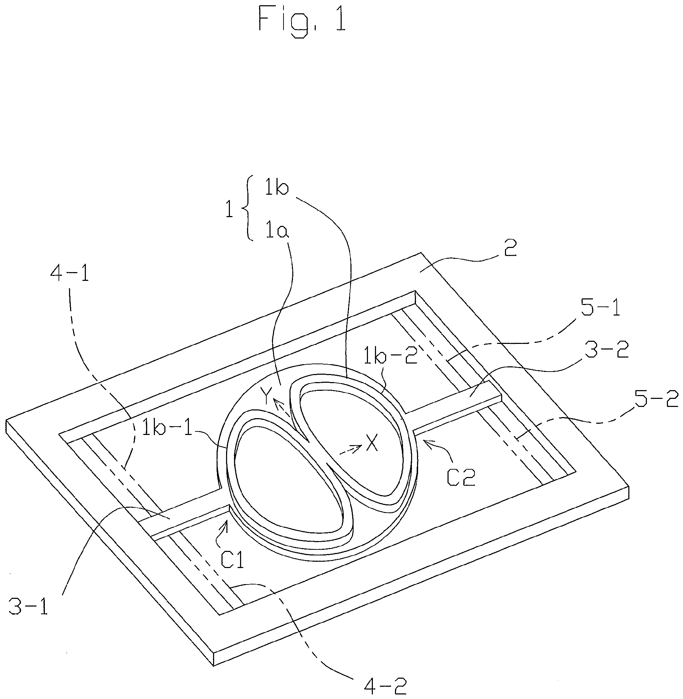

In Fig. 1 , which is a rear-side perspective view illustrating a first embodiment of the one-dimensional optical deflector according to the presently disclosed subject matter, this optical deflector is constructed by an optical deflecting mirror device 1, a support frame 2 supporting the optical deflecting mirror device 1, a pair of torsion bars 3-1 and 3-2 coupled between the support frame 2 and the optical deflecting mirror device 1, and two pairs of piezoelectric actuators 4-1 and 4-2; 5-1 and 5-2 serving as cantilevers, coupled between the support frame 2 and the torsion bars 3-1 and 3-2, for rocking the optical deflecting mirror device 1 around an X-axis through the torsion bars 3-1 and 3-2. The optical deflecting mirror device 1 is coupled to the torsion bars 3-1 and 3-2 at their coupling portions C1 and C2.

Also, the optical deflecting mirror device 1 includes a circular or elliptic mirror 1a with a reflective front surface, and a figure "8 "-shaped reinforcement rib 1b provided on a rear surface of the mirror 1a symmetrical with respect to the X-axis serving as a rocking axis. In this case, the figure "8 "-shaped reinforcement rib 1b consists of ring-shaped reinforcement ribs 1b-1 and 1b-2 coupled to each other along the X-axis. The minimum distance between the figure "8"-shaped reinforcement rib 1b and the outer circumference of the mirror 1a is about 40 µm. Also, the thickness of the mirror 1a is the same as that of the torsion bars 3-1 and 3-2, i.e., about 40 µm. Further, the figure "8"-shaped reinforcement rib 1b is about 100 µm wide and about 150 to 200 µm thick. On the other hand, the support frame 2 is about 400 to 500 µm thick.

In Fig. 1, the central reinforcement rib 301c of Fig. 9 and the farthest portions of the ring-shaped reinforcement rib 301b of Fig. 9 from the X-axis are removed to thereby realize the figure "8"-shaped reinforcement rib 1b which has an X-shaped center portion formed by crossed beams sloped at an angle of ±15 to 30 degrees with respect to a Y-axis. Thus, the moment of inertia of the optical deflecting mirror device 1 is much smaller than that of the optical deflecting mirror device 301' of Fig. 9. For example, if the sizes of the mirror 1a and the figure "8"-shaped reinforcement rib 1b are defined as stated above, the resonant frequency "f" of the optical deflecting mirror device 1 is about 26.8 kHz (see Fig. 4), which would satisfy the resonant frequency requirement where f > f_{R} = 26.5 kHz. Thus, the optical deflecting mirror device 1 can be driven at a higher speed than the required speed.

On the other hand, the rigidity of the optical deflecting mirror device 1 having the figure "8"-shaped reinforcement rib 1b is smaller than that of the optical deflecting mirror device 301' of Fig. 9 having the ring-shaped reinforcement rib 301b and the central reinforcement rib 301c; however, the reduction of the rigidity is compensated for by the X-shaped center portion of the figure "8"-shaped reinforcement rib 1b. Therefore, the reduction of the rigidity is small, so that the increase of the dynamic face-deflection peak-to-valley amount D is small. Actually, the dynamic face-deflection peak-to-valley amount D of the optical deflecting mirror device 1 is about 25 nm (see Fig. 4) which is a little larger than the dynamic face-deflection peak-to-valley amount D (= 12 nm) of the optical deflecting mirror device 301' of Fig. 9, thus satisfying the dynamic face-deflection peak-to-valley amount requirement where D < D_{R} = 45 nm. As a result, the optical characteristics of reflected light of the optical deflecting mirror device 1 would satisfy the required optical characteristics in optical scanners for high definition projectors.

Thus, according to the first embodiment, the suppression of the dynamic face-deflection peak-to-valley amount D of the optical deflecting mirror device 1 can be realized simultaneously with the increase of the resonant frequency "f" of the optical deflecting mirror device 1.

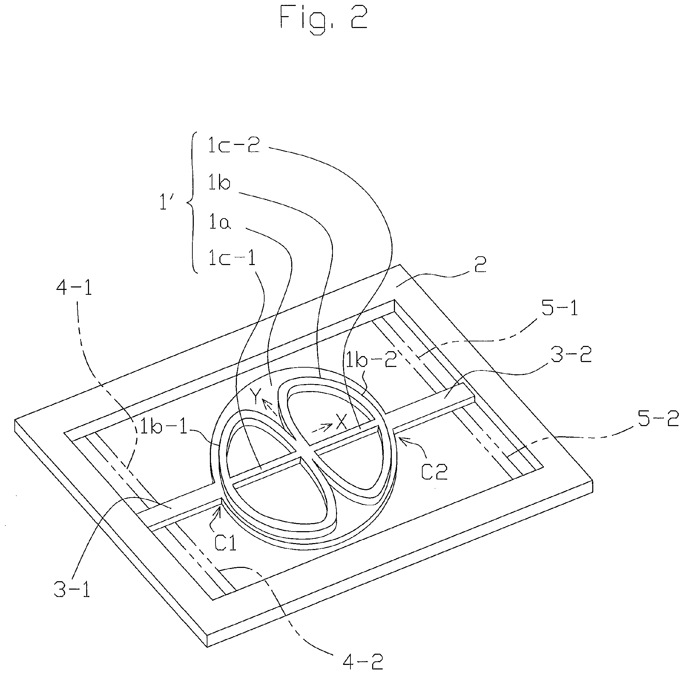

In Fig. 2, which is a rear-side perspective view illustrating a second embodiment of the one-dimensional optical deflector according to the presently disclosed subject matter, linear reinforcement ribs 1c-1 and 1c-2 are added to the elements of the optical deflecting mirror device 1 of Fig. 1, to realize an optical deflecting mirror device 1'. That is, the linear reinforcement rib 1c-1 is coupled between the inner ends of the ring-shaped reinforcement rib 1b-1 along the X-axis, while the linear reinforcement rib 1c-2 is coupled between the inner ends of the ring-shaped reinforcement rib 1b-2 along the X-axis. Also, the width and thickness of the linear reinforcement ribs 1c-1 and 1c-2 are the same as those of the figure "8"-shaped reinforcement rib 1b.

In Fig. 2, due to the presence of the linear reinforcement ribs 1c-1 and 1c-2, the rigidity of the optical deflecting mirror device 1' is larger than that of the optical deflecting mirror device 1 of Fig. 1, so that the dynamic face-deflection peak-to-valley amount D is decreased to about 20 nm as illustrated in Fig. 4. On the other hand, since the linear reinforcement ribs 1c-1 and 1c-2 are arranged along the X-axis (rocking axis), the increase of the moment of inertia of the optical deflecting mirror device 1' as compared with that of the optical deflecting mirror device 1 of Fig. 1 is small. As a result, the resonant frequency "f" of the optical deflecting mirror device 1' is slightly smaller than that of the optical deflecting mirror device 1 of Fig. 1, i. e., about 26.7 kHz as illustrated in Fig. 4. Therefore, in the optical deflecting mirror device 1' of Fig. 2, although the resonant frequency "f" is slightly low, the dynamic face-deflection peak-to-valley amount D is improved. Thus, the optical characteristics of reflected light of the optical deflecting mirror device 1' would satisfy the required optical characteristics where D < D_{R} = 45 nm in optical scanners for high definition projectors, and the resonant frequency "f" of the optical deflecting mirror device 1' would satisfy the resonant frequency requirement where f > f_{R} = 26.5 kHz, thus, driving the optical deflecting mirror device 1' at a higher speed than the required speed.

Fig. 3 is a rear-side perspective view illustrating a third embodiment of the one-dimensional optical deflector according to the presently disclosed subject matter.

In Fig. 3, an optical deflecting mirror device 1" is constructed by the mirror 1a and a figure "8"-shaped reinforcement rib 1b'. In the figure "8"-shaped reinforcement rib 1b', the ring-shaped reinforcement ribs 1b-1 and 1b-2 of Fig. 1 are replaced by ring-shaped reinforcement ribs 1b'-1 and 1b'-2 whose end portions along the X-axis are recessed. Therefore, recess portions 1b"-1 and 1b"-2 are created at coupling portions C1' and C2' between the optical deflecting mirror device 1" and the torsion bars 3-1 and 3-2. The frontage of the recess portions 1b"-1 and 1b"-2 is about 200 to 250 µm long. As a result, a stress concentration at the coupling portions C1' and C2' can be relaxed, to thereby avoid the mechanical destruction thereof.

In the optical deflector of Fig. 1, note that, when the optical deflecting mirror device 1 is rocked through the torsion bars 3-1 and 3-2, a stress concentration occurs at the coupling portions C1 and C2. Concretely, the stress (in this case, the Mises stress) on the rear side of the coupling portions C1 and C2 is anisotropically large due to the presence of the figure "8"-shaped reinforcement rib 1b, so that a stress slope on the rear side of the coupling portions C1 and C2 is large. On the other hand, the stress (in this case, the Mises stress) on the front side of the coupling portions C1 and C2 is isotropically small due to the absence of the figure "8"-shaped reinforcement rib 1b, so that a stress slope on the front side of the coupling portions C1 and C2 is small. As a result, the stress distribution on the rear side of the coupling portions C1 and C2 is asymmetrical to the stress distribution on the front side of the coupling portions C1 and C2, so that the coupling portions C1 and C2, particularly, the torsion bars 3-1 and 3-2 would be mechanically broken. For example, when the rocking angle is larger than 10°, the torsion bars 3-1 and 3-2 would often be mechanically broken. Similarly, in the optical deflector of Fig. 2, the torsion bars 3-1 and 3-2 would be mechanically broken.

Conversely, in the optical deflector of Fig. 3, the stress (in this case, the Mises stress) on the rear side of the coupling portions C1' and C2' is isotropically large due to the presence of the recess portions 1b"-1 and 1b"-2 opposing the figure "8"-shaped reinforcement rib 1b', so that a stress slope on the rear side of the coupling portions C1' and C2' is small. As a result, the stress distribution on the rear side of the coupling portions C1' and C2' is symmetrical to the stress distribution on the front side of the coupling portions C1' and C2', so that the coupling portions C1' and C2', particularly, the torsion bars 3-1 and 3-2 would not be mechanically broken.

In the optical deflector of Fig. 3, since the recess portions 1b"-1 and 1b"-2 are provided in the figure "8"-shaped reinforcement rib 1b', the rigidity of the optical deflecting mirror device 1" is slightly decreased to slightly increase the dynamic face-deflection peak-to-valley amount D to about 30 nm as illustrated in Fig. 4. Also, the moment of inertia is slightly increased, the resonant frequency "f" is slightly decreased to about 26.7 kHz, as illustrated in Fig. 4. However, the optical deflecting mirror device 1" would satisfy the required dynamic face-deflection peak-to-valley amount D where D < D_{R} = 45 nm and the required resonant frequency where f > f_{R} = 26.5 kHz.

The one-dimensional optical deflectors of Figs. 1, 2 and 3 can be applied to a two-dimensional optical deflector.

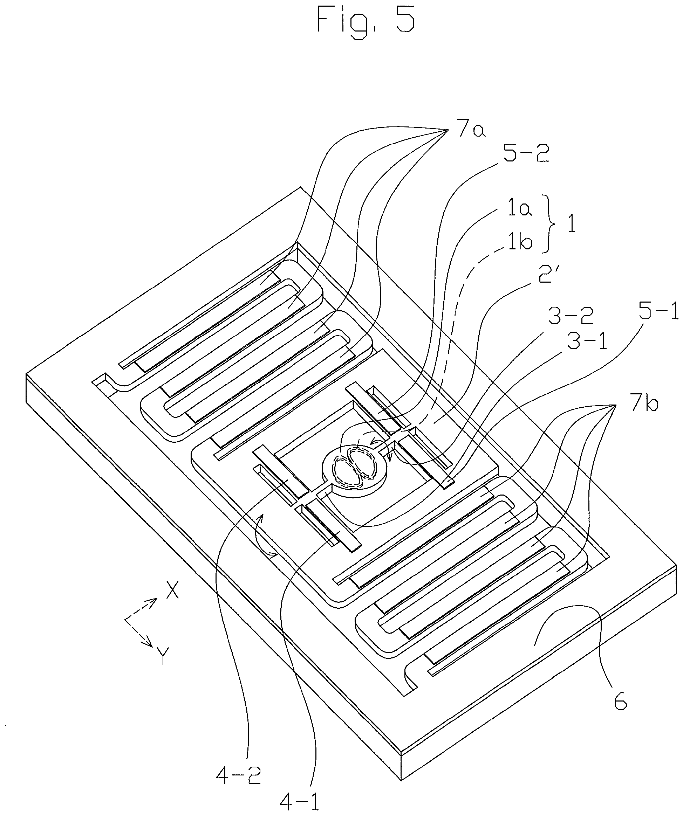

In Fig. 5, which is a front-side perspective view illustrating a two-dimensional optical deflector to which the one-dimensional optical deflector of Fig. 1 is applied, the support frame 2 of Fig. 1 is replaced by an inner support frame 2' whose thickness is the same as that of the torsion bars 3-1 and 3-2. Additionally, an outer support frame 6 is provided to surround the inner support frame 2'. Further, coupled between the outer support frame 6 and the inner support frame 2' are a pair of meander-type piezoelectric actuators 7a and 7b. In this case, the outer support frame 6 is about 400 to 500 µm thick. Thus, the meander-type piezoelectric actuators. 7a and 7b can rock the mirror 1a around the Y-axis through the inner support frame 2'.

In Fig. 5, instead of the meander-type piezoelectric actuators 7a and 7b, a pair of outer torsion bars can be coupled between the outer support frame 6 and the inner support frame 2', and two pairs of piezoelectric actuators can be coupled between the outer support frame 6 and the outer torsion bars to rock the inner support frame 2' through the outer torsion bars along the Y-axis.

Also, the one-dimensional optical deflector of Fig. 2 or 3 can be applied to the two-dimensional optical deflector of Fig. 5.

Further, in the above-described embodiments, only one torsion bar can be provided instead of the pair of torsion bars for rocking the mirror around the X-axis. Similarly, only one meander-type actuator or only one outer torsion bar can be provided instead of the pair of meander-type actuators or the pair of outer torsion bars.

Furthermore, in the above-described embodiments, electrostatic actuators or electromagnetic actuators can be provided instead of the piezoelectric actuators.

It will be apparent to those skilled in the art that various modifications and variations can be made in the presently disclosed subject matter without departing from the scope of the appended claims.

## Claims

1. An optical deflecting mirror device comprising:
a mirror (1a) with a reflective front surface;
and
a figure "8"-shaped reinforcement rib (1b, 1b') provided on a rear surface of said mirror (1a) symmetrically along a rocking axis (X) of said mirror (1a),
**characterized in that**
said figure "8"-shaped reinforcement rib (1b, 1b') consists of two ring-shaped reinforcement ribs (1b-1, 1b-2; 1b'-1, 1b'-2) coupled to each other along said rocking axis (X).

2. The optical deflecting mirror device as set forth in claim 1, further comprising two linear reinforcement ribs (1c-1, 1c-2) provided on the rear-side surface of said mirror (1a) along said rocking axis (X),
each of said linear reinforcement ribs (1c-1, 1c-2) being coupled between two inner ends of one of said ring-shaped reinforcement ribs (1b-1, 1b-2).

3. The optical deflecting mirror device as set forth in claim 1, wherein end portions of said figure "8"-shaped reinforcement rib (1b') are recessed.

4. The optical deflecting mirror device as set forth in claim 1, wherein said mirror (1a) is circular.

5. The optical deflecting mirror device as set forth in claim 1, wherein said mirror (1a) is elliptical.

6. An optical deflector, comprising:
the optical deflecting mirror device as set forth in any one of claims 1 to 5, a first support frame (2, 2') to support said mirror (1a);
at least one first torsion bar (3-1, 3-2) coupled between said first support frame (2, 2') and said mirror (1a);
a first actuator (4-1, 4-2; 5-1, 5-2), coupled between said first support frame (2, 2') and said first torsion bar (3-1, 3-2), to rock said mirror (1a) around said first torsion bar (3-1, 3-2); and
said figure "8"-shaped reinforcement rib (1b, 1b') provided on the rear surface of said mirror (1a) symmetrically along said torsion bar (3-1, 3-2), said figure "8"-shaped reinforcement rib (1b, 1b') consisting of two ring-shaped reinforcement ribs (1b-1, 1b-2; 1b'-1, 1b'-2) coupled to each other along said first torsion bar (3-1, 3-2).

7. The optical deflector as set forth in claim 6,
wherein said optical deflector further comprises:
a second support frame (6) to support said first support frame (2');
at least one second actuator (7a, 7b), coupled between said second support frame (6) and said first support frame (2'), to rock said first support frame (2') around an axis (Y) perpendicular to said first torsion bar (3-1, 3-2).

8. The optical deflector as set forth in claim 7,
wherein said second actuator (7a, 7b) comprises a meander-type actuator.

## Patentansprüche

1. Optisch ablenkende Spiegelvorrichtung, die Folgendes aufweist:
einen Spiegel (1a) mit einer reflektierenden Vorderoberfläche; und
eine Verstärkungsrippe (1b, 1b') in Form einer 8, die auf einer Rückoberfläche des Spiegels (1a) vorgesehen ist, und zwar symmetrisch entlang einer Schwenkachse (X) des Spiegels (1a),
**dadurch gekennzeichnet, dass**
die Verstärkungsrippe (1b, 1b') in Form einer 8 aus zwei ringförmigen Verstärkungsrippen (1b-1, 1b-2, 1b'-1, 1b'-2) besteht, die miteinander entlang der Schwenkachse (X) gekoppelt sind.

2. Optisch ablenkende Spiegelvorrichtung gemäß Anspruch 1, die ferner zwei lineare Verstärkungsrippen (1c-1, 1c-2) aufweist, die auf der Rückseitenoberfläche des Spiegels (1a) entlang der Schwenkachse (X) vorgesehen sind, wobei jede lineare Verstärkungsrippe (1c-1, 1c-2) zwischen zwei innere Enden von einer der ringförmigen Verstärkungsrippen (1b-1, 1b-2) gekoppelt ist.

3. Optisch ablenkende Spiegelvorrichtung gemäß Anspruch 1, wobei Endteile der Verstärkungsrippe (1b') in der Form einer 8 ausgenommen sind.

4. Optisch ablenkende Spiegelvorrichtung gemäß Anspruch 1, wobei der Spiegel (1a) kreisförmig ist.

5. Optisch ablenkende Spiegelvorrichtung gemäß Anspruch 1, wobei der Spiegel (1a) elliptisch ist.

6. Optische Ablenkvorrichtung, die Folgendes aufweist:
die optisch ablenkende Spiegelvorrichtung gemäß einem der Ansprüche 1 bis 5;
einen ersten Stützrahmen (2, 2'), um den Spiegel (1a) zu stützen;
zumindest eine erste Torsionsstange (3-1, 3-2), die zwischen den ersten Stützrahmen (2, 2') und den Spiegel (1a) gekoppelt ist;
eine erste Betätigungsvorrichtung (4-1, 4-2; 5-1, 5-2), die zwischen den ersten Stützrahmen (2, 2') und die Torsionsstange (3-1, 3-2) gekoppelt ist, um den Spiegel (1a) um die erste Torsionsstange (3-1, 3-2) zu schwenken; und
die Verstärkungsrippe (1b, 1b') in der Form einer 8, die auf der Rückoberfläche des Spiegels (1a) symmetrisch entlang der Torsionsstange (3-1, 3-2) vorgesehen ist, wobei die Verstärkungsrippe (1b, 1b') in der Form einer 8 aus zwei ringförmigen Verstärkungsrippen (1b-1, 1b-2; 1b'-1, 1b'-2) besteht, die miteinander entlang der ersten Torsionsstange (3-1, 3-2) gekoppelt sind.

7. Optische Ablenkvorrichtung gemäß Anspruch 6,
wobei die optische Ablenkvorrichtung ferner Folgendes aufweist:
einen zweiten Stützrahmen (6) zum Stützen des ersten Stützrahmens (2');
zumindest eine zweite Betätigungsvorrichtung (7a, 7b), die zwischen den zweiten Stützrahmen (6) und den ersten Stützrahmen (2') gekoppelt ist, um den ersten Stützrahmen (2') um eine Achse (Y), die senkrecht zu der ersten Torsionsstange (3-1, 3-2) ist, zu schwenken.

8. Optische Ablenkvorrichtung gemäß Anspruch 7,
wobei die zweite Betätigungsvorrichtung (7a, 7b) eine Betätigungsvorrichtung der Mäanderbauart aufweist.

## Revendications

1. Dispositif formant miroir de déflexion optique comprenant :
un miroir (1a) ayant une surface avant réfléchissante ; et
une nervure de renfort en forme de "8" (1b, 1b') prévue sur une surface arrière du miroir (1a) symétriquement par rapport à un axe de basculement (X) du miroir (1a),
**caractérisé en ce que**
la nervure de renfort en forme de "8" (1b, 1b') est constituée de deux nervures de renfort en forme d'anneau (1b-1, 1b-2, 1b'-1, 1b'-2) couplées entre elles le long de l'axe de basculement (X).

2. Dispositif formant miroir de déflexion optique selon la revendication 1, comprenant en outre deux nervures de renfort linéaires (1c-1, 1c-2) prévues sur la surface du côté arrière du miroir (1a) le long de l'axe de basculement (X),
chacune des nervures de renfort linéaires (1c-1, 1c-2) étant couplée entre deux extrémités intérieures de l'une des nervures de renfort en forme d'anneau (1b-1, 1b-2).

3. Dispositif formant miroir de déflexion optique selon la revendication 1, dans lequel des portions d'extrémité de la nervure de renfort en forme de "8" (1b') sont en renfoncement.

4. Dispositif formant miroir de déflexion optique selon la revendication 1, dans lequel le miroir (1a) est circulaire.

5. Dispositif formant miroir de déflexion optique selon la revendication 1, dans lequel le miroir (1a) est elliptique.

6. Déflecteur optique comprenant :
le dispositif formant miroir de déflexion optique selon l'une quelconque des revendications 1 à 5, un premier cadre support (2, 2') pour supporter le miroir (1a) ;
au moins une première barre de torsion (3-1, 3-2) couplée entre le premier cadre support (2, 2') et le miroir (1a) ;
un premier actionneur (4-1, 4-2 ; 5-1, 5-2), couplé entre le premier cadre support (2, 2') et la première barre de torsion (3-1, 3-2), pour faire basculer le miroir (1a) autour de la première barre de torsion (3-1, 3-2) ; et
la nervure de renfort en forme de "8" (1b, 1b') prévue sur la surface arrière du miroir (1a) symétriquement par rapport à la barre de torsion (3-1, 3-2), la nervure de renfort en forme de "8" (1b, 1b') étant constituée de deux nervures de renfort en forme d'anneau (1b-1, 1b-2, 1b'-1, 1b'-2) couplées entre elles le long de la première barre de torsion (3-1, 3-2).

7. Déflecteur optique selon la revendication 6,
dans lequel le déflecteur optique comprend en outre :
un deuxième cadre support (6) pour supporter le premier cadre support (2') ;
au moins un deuxième actionneur (7a, 7b), couplé entre le deuxième cadre support (6) et le premier cadre support (2'), pour faire basculer le premier cadre support (2') autour d'un axe (Y) perpendiculaire à la première barre de torsion (3-1, 3-2).

8. Déflecteur optique selon la revendication 7,
dans lequel le deuxième actionneur (7a, 7b) comprend un actionneur du type à méandres.
